## Europäisches Patentamt

(19) **European Patent Office**

**Office européen des brevets**

(11) Publication number: **0 164 838**
**B1**

---

(12) **EUROPEAN PATENT SPECIFICATION**

(45) Date of publication of patent specification: **08.08.90**

(21) Application number: **85302558.3**

(22) Date of filing: **11.04.85**

(51) Int. Cl.⁵: **G 01 R 31/08**

---

(54) **Event location using a locating member containing discrete impedances.**

---

(30) Priority: **07.06.84 US 618106**

(43) Date of publication of application:
**18.12.85 Bulletin 85/51**

(45) Publication of the grant of the patent:
**08.08.90 Bulletin 90/32**

(84) Designated Contracting States:
**AT BE CH DE FR GB IT LI NL SE**

(56) References cited:
**DE-A-3 209 560**
**GB-A-1 481 850**
**US-A-2 581 213**
**US-A-3 991 413**

(73) Proprietor: **RAYCHEM CORPORATION (a Delaware corporation)**
**300 Constitution Drive**
**Menlo Park, California 94025 (US)**

(72) Inventor: **Haupily, Paul D.**
**4583 Mildred Drive**
**Fremont California 94536 (US)**

(74) Representative: **Benson, John Everett et al**
**Raychem Limited Intellectual Property Law**
**Department Faraday Road Dorcan**
**Swindon, Wiltshire SN3 5HH (GB)**

---

Courier Press, Leamington Spa, England.

## Description

This invention relates to methods and apparatus for detecting and obtaining information about (particularly locating) changes in variables, and is related to the applications already filed, EP-A-0133748 published 06.03.85, EP-A-0253085 published 20.01.88 and EP-A-0250776 published 07.01.88 (corresponding to US Serial Nos. 509,897 and 457,882 (MP0869-US1 and US2)) and to the application being filed at the same time as this application, EP-A-0160440, published 06.11.85, (corresponding to U.S. Serial No. 599,048 (MP0869-US3)), which are referred to herein as the Masia/Reed applications.

A number of methods have been proposed for use to detect changes in variables along an elongate path, eg. the occurrence of a leak (of water or another liquid or gas), insufficient or excessive pressure, too high or too low a temperature, the presence or absence of light or another form of electromagnetic radiation, or a change in the physical position of a movable member, eg. a valve in a chemical process plant or a window in a building fitted with a burglar alarm system. Changes of this kind are referred to in this specification by the generic term "event". Reference may be made for example to US Patents US-A-1,084,910, 2,581,213, 3,248,646 3,384,493, 3,800,216 and 3,991,413, UK Patent GB-A-1,481,850 and German Offenlegungsschriften DE-A-3,001,150.0 and DE-A-3,225,742. The Masia/Reed applications describe improved systems in which the location of an event is determined by measuring the voltage drop down a locating member having known impedance characteristics and to which connection is made when an event takes place.

The application already filed EP-A-0144211, published 12.06.85, (corresponding to US Serial Nos. 556,740 and 556,829 (MP0892)) describes preferred ways of assembling the locating, return and source members, at least one of the members having a wrapped configuration, and the application being filed at the same time as this application, EP-A-0160441 published 06.11.1985 (corresponding to US Serial No. 603,484 (Bonomi/Frank, MP0932-US1)), describes modifications of the Masia/Reed systems.

In the copending applications referred to above, a key feature is that, under the conditions of operation, the impedance of the locating member changes in a known fashion along the length of the member.

US-A-3991413 discloses a system of detecting and locating the deroping of a cable from the grooved wheels on a tower of a chair lift system. A constant current source (22) supplies power to an elongate circuit which comprises first and second elongate members (34, 46) which are connected through a resistor (40) at the far end of the circuit. At spaced intervals along the loop, there are sensors (38) which will react to deroping of the cable by closing a switch (44) to connect the first and second members together, thus short circuiting the remainder of the circuit. Each sensor comprises a resistor (42), so that the location at which a sensor has connected the members together can be determined.

I have now discovered that great benefits can be obtained, in the methods and apparatus disclosed in the Masia/Reed applications, from the use of a locating member which comprises

(a) a plurality of spaced-apart discrete impedant components, each of which has substantial impedance, and

(b) a plurality of elongate intermediate components, each of which physically separates and electrically connects a pair of impedant components.

When such a locating member is used, the system is arranged so that, upon occurrence of an event, connection is made to the locating member at one or more of a plurality of available connection points, each of which lies between two impedant components. As a result, a plot of the possible voltage drops against the distance from the second point (usually one end of the locating member) to the first point has a succession of discontinuities in it, corresponding to the impedant components.

In one aspect, the invention provides a method for monitoring for the occurrence of an event, and for detecting and obtaining information about the event upon its occurrence, which method comprises providing a system in which, upon occurrence of the event,

(1) electrical connection is made between an electrically conductive locating member and an electrically conductive second member;

the locating member comprising

(a) a plurality of spaced apart, discrete impedant components, each of which has substantial impedance, and

(b) a plurality of elongate intermediate components, each of which physically separates and electrically connects a pair of impedant components;

the connection to the locating member being made at at least one of a plurality of available connection points which lie between the impedant components, and at which the locating member and/or the second member comprises event-sensitive connection means that comprises a metal core and a jacket (i) which electrically surrounds the core, (ii) which is composed of a conductive polymer, and (iii) through which the connection is made and the connection being effective at a first point whose location is defined by at least one characteristic of the event; the making of the connection enabling the formation of a test circuit which comprises that part of the locating member between the first point and a second point on the locating member having a known location, and in which an electrical current of known size is transmitted between the first and second points on the locating member; and the current and the locating member being such that, by measuring the voltage drop between the first and second points, the spatial relationship between the first and second points can be determined;

(2) the voltage drop between the first and second points is measured; and

(3) information concerning the event is obtained from the measurement made in step (3).

The invention also provides an apparatus for detecting and obtaining information about an event, by a method as herein described, which apparatus comprises

(1) an elongate electrically conductive locating member which comprises

(a) a plurality of spaced-apart, discrete impedant components, each of which has substantial impedance, and

(b) a plurality of elongate intermediate members, each of which physically separates and electrically connects a pair of impedant components;

(2) an elongate electrically conductive second member;

(3) a plurality of event-sensitive connection means

(a) which are placed at discrete available connection points,

(b) which lie between the impedant components,

(c) which comprise a metal core and a jacket (i) which electrically surrounds the core, and (ii) which is composed of a conductive polymer, and

(d) at one or more of which, upon occurrence of an event, electrical connection is effected between the locating member and the second member through the conductive polymer jacket, the connection being effective at a first point on the locating member which is defined by at least one characteristic of the event;

(4) an electrically conductive third member;

(5) a voltage-measuring device for determining the voltage drop between the first point and a second point which is at one end of the locating member, the voltage measuring device being connected to the first point or to the other end of the locating member through the third member; and

(6) a power source which is electrically connected to the second point on the locating member and, which, at least when occurrence of an event causes electrical connection to be made between the locating and second members, causes a current of known size to be transmitted between the first and second points on the locating member.

In another aspect, the invention provides an event-sensitive module which is suitable for use in the method and apparatus defined above and which comprises

(1) a discrete impedant component having substantial impedance;

(2) a first conductor which has a relatively very small impedance and which is connected in series with the impedant component;

(3) a second conductor which also has a relatively very small impedance and which, in the absence of an event, is electrically insulated from the first conductor and the impedant component; and

(4) an event-sensitive connection means which comprises a metal core and a jacket (i) which electrically surrounds the core, (ii) which is composed of a conductive polymer and (iii) through which, upon occurrence of an event, electrical connection is effected between the first and second conductors;

the impedant component and the first conductor being connectable in series with incoming and outgoing portions of elongate intermediate components of an elongate electrically conductive locating member, and the second conductor being connectable in series with incoming and outgoing portions of elongate intermediate components of an elongate electrically conductive second member.

Brief Description of the Drawings

The invention is illustrated in the accompanying drawing in which

Figures 1 to 4 are schematic circuit diagrams of the method and apparatus of the invention, and

Figures 5 to 8 are circuit diagrams of event-sensitive modules of the present invention.

Detailed Description of the Invention

The invention is of particular value when it is desired to monitor for a change in a variable which can only take place at one or more of a plurality of discrete locations. One example of such a situation is in a chemical process plant where the position of valves is to be monitored. Another example is a building in which the positions of doors or windows are to be monitored.

The invention is also particularly valuable for monitoring a system in which a change in a variable can take place at a number of different locations (which may be continuous or discrete), but in which it is possible to select a relatively small number of discrete locations as providing an adequate basis for monitoring. One example of such a situation is where the existence of a leak from a tank can be adequately monitored by placing a single leak detector at a low point beneath the tank, or by placing a plurality of leak detectors at spaced locations beneath the tank.

In situations such as those outlined above, an event-sensitive connection means is placed at each of the discrete locations, and at least one impedant component is placed in the locating member between each event-sensitive connection means. Usually it will be convenient for a single impedant component to be placed adjacent the event-sensitive connection means, preferably making use of an event-sensitive module which comprises

(1) an impedant component which can be connected in series with intermediate components of the locating member,

(2) an electrical connection means which can be connected in series with parts of the second member, and

(3) an event-sensitive connection means which, upon occurrence of an event, can effect electrical connection between the locating member and the second member.

Such modules are novel and form part of the present invention.

The invention is also particularly useful when it is desired to monitor a system which includes a number of branch lines along each of which a change in a variable can take place in a number of different locations (which may or may not be discrete), but in which system it is adequate to know, when a change in a variable has taken place along one of the branch lines, which of the branch lines is involved. In such situations, one or more event-sensitive connection means (including continuous event-sensitive connection means) are placed along each of the branch lines.

As previously noted, a key feature of the earlier applications is that, under the conditions of operation, the impedance of the locating member is dependent substantially only on the distance between the first and second points. The extent of any permissible variation in the impedance will of course be dependent on the accuracy with which the location of the first point must be calculated. This means, for example, that if (as is often the case) the temperature may vary along the length of the locating member, it is necessary, when calculating the location of the first point from the voltage drop, either (a) to compensate for any change in impedance with temperature (which can only be done if the change in temperature and the temperature coefficient of impedance are known), or (b) to make use of a locating member which has a very low temperature coefficient of impedance. In practice, alternative (b) has been greatly preferred, leading to the use of locating wires which are made of Constantan or another alloy having a very low temperature coefficient of impedance. One of the advantages of the present invention is that if, as is preferred, there is at most one available connection point between each pair of adjacent impedant components, then the accuracy of the information obtained about the event is not affected by unknown variations in the impedance of one or more of the components of the locating member, providing that the total variation in the impedance of the locating member, between the first and second points, is substantially less than the impedance of any one of the impedant components. This follows from the fact that a plot of distance against possible voltage drop, along the locating member, shows a series of discontinuities. The same is true when there is more than one available connection point between each pair of adjacent impedant components, providing that the only information required is that an event has taken place at some point between two impedant components, without any need to identify more precisely the location of the event. Thus in the present invention, it is possible, for example, to use standard insulated copper wire to provide the elongate intermediate components of the locating member, and to use standard resistors as the impedant components of the locating member.

Preferably each of the impedant components has an impedance which is substantially higher than, particularly at least 100 times, especially at least 1000 times, the total impedance of all of the intermediate components. Preferably both the impedant and the intermediate components have resistance but substantially no reactance. The resistors used as impedant components can for example have a resistance of at least 0.1 ohms, particularly 1 to 1000 ohms. The impedant components can all be the same or they can be different. The intermediate components can be of the same or different lengths, depending on the distances between the locations of the desired available connection points. Preferably each of the intermediate components is of the same cross-section throughout its length, and the different intermediate components have the same cross-section.

As those skilled in the art will realize, the "electrical center" of a plurality of discrete connections can be calculated if the resistances of all the components in the various circuits are known. The ability to make this calculation is of no value when connection to the locating member can be made at any point along its length, or at any point along extended sections of its length. It is also of no value when the resistances of the different connections are unknown. It is also of little or no value when connection to the locating member can only be made at discrete points and the impedance of the locating member varies continuously with its distance from the second point. However, when the locating member comprises a plurality of discrete impedant components of known size, as in the present invention, and the impedances of the various different components which can form part of the test circuit are known, then in many cases it is possible, by appropriate selection of the various impedances, to design a system in which it is possible to ascertain, from the voltage drop shown by the voltage-measuring device, which combination of connections has been made. Thus the invention includes methods and apparatus in which the connections which can be made, upon occurrence of an event, are of known impedance, and the impedant components are selected so that, when connection is made between the locating and second members, each combination of possible connections gives rise to a voltage drop which is unique to that combination or which is characteristic of one of a relatively small number of combinations. The impedances of the various available connections can be the same or different (and can be substantially zero). Thus one or more of the available connections can have associated therewith an additional impedant component so that when (but only when) connection is made at that available connection point, an additional known impedance is introduced into the test circuit. The additional known impedance can be introduced into the connection between the locating and second members and/or into the locating member. It is also possible to arrange the switching, when an event occurs, so that an impedant component is removed from the locating member. The number of available connections which can be placed in a system of this kind will depend inter alia upon the precision with which the various impedances are known, the accuracy of the voltage-measuring device, and the number of combinations which the use of the system will allow any particular voltage drop to represent.

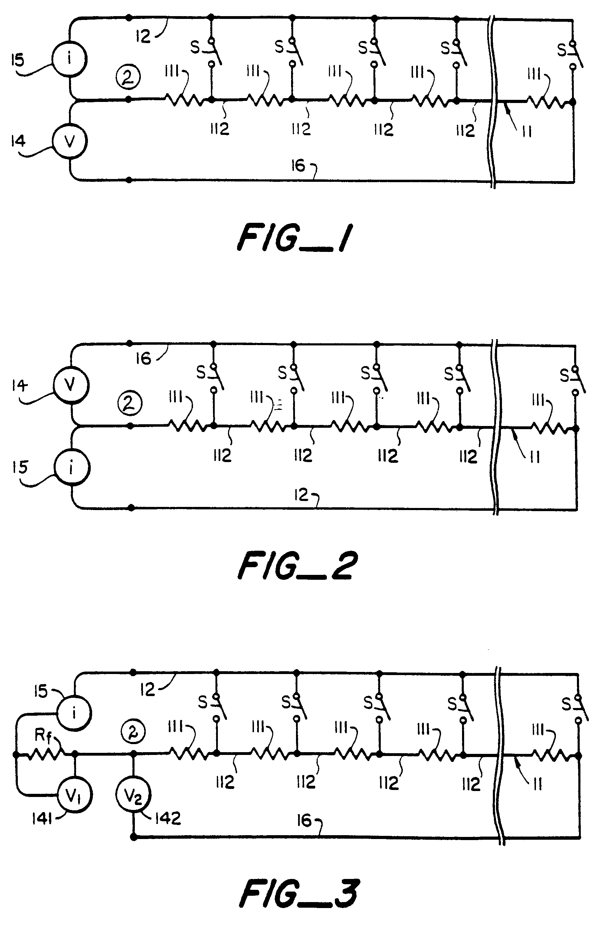

Referring now to Figure 1, this shows a system of the general kind disclosed in MP0869-US1 and US2. It comprises a locating member 11; a second (or source) member 12 which is connected through a constant current source 15 to end (2) of the locating member 11, but in the absence of an event is otherwise insulated from the locating member; and a third (or return) member 16 which is connected to both ends of the locating member through a voltage-measuring device 14. The system of Figure 1 differs from that shown in MP0869-US1 and US2 (corresponding to EP-A-0 133 748) in that the locating member comprises a plurality of spaced-apart resistors 111 separated by low resistance intermediate components 112; in Figure 1 and the other Figures, all the intermediate components are shown as being of the same short lengths, but in practice they can be of different lengths and can be short or long, e.g. from less than 1 meter to many hundreds of meters. At spaced-apart locations along the locating and second members, are placed event-sensitive connection means, which are shown as switches 5 but could be any connection means which, upon occurrence of the event, will make a connection of any kind between the two members.

Figure 2 is similar to Figure 1 but shows a system of the general kind disclosed in MP0869-US3, (corresponding to EP-A-0 160 440) i.e. a system of which the source member 12 is connected to both ends of the locating member, and the return member 16 is connected to end (2) of the locating member but otherwise becomes connected to the locating member only through the event-connection means, which in this system must make a connection of known impedance between the locating and return members. Just as the system of Figure 1 differs from the system of MP0869-US1 and MP0869-US2, (EP-A-0 133 748), so also the system of Figure 2 differs from the system of MP0869-US3 (EP-A-0 160 440) by the use of a locating member comprising discrete impedant components (resistors 111) and intermediate components 112.

Figure 3 is similar to Figure 1, but includes the modification disclosed in the Bonomi/Frank application (MP0932-US1), (corresponding to EP-A-0 160 441) namely the use of a reference resistor Rf connected in series with the locating member and two voltmeters 141 and 142 connected across the reference resistor and the locating member respectively; in this way, the location(s) at which switch(es) S has(have) closed, due to occurrence of an event, can be determined by comparing the voltage drops down the locating member and the reference resistor.

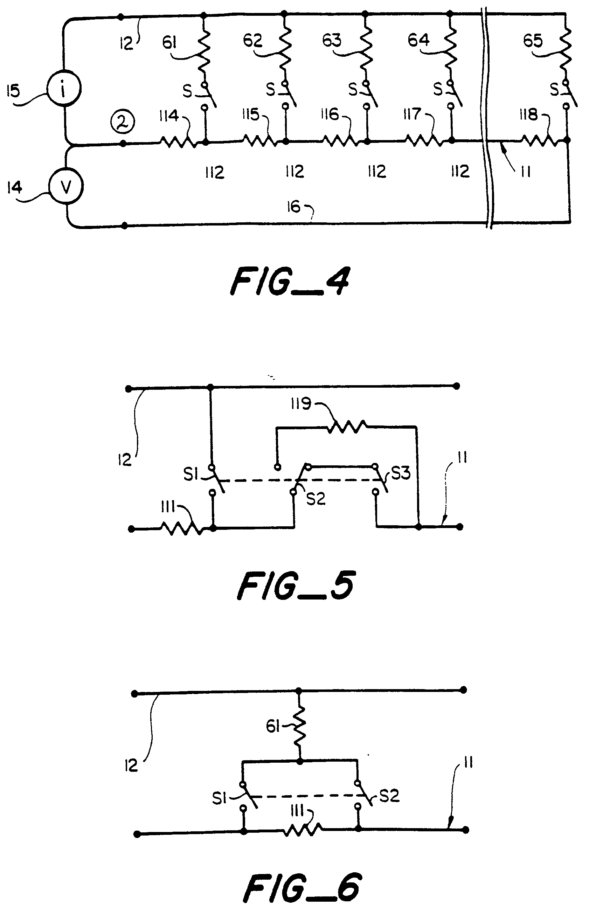

Figure 4 is similar to Figure 1, but makes use of resistors 114, 115, 116, 117, and 118 in place of resistors 112, and includes resistors 61, 62, 63, 64, and 65 which are brought into the test circuit when the corresponding switch S closes upon occurrence of an event. The sizes of the resistors 114, 115, 116, 117, 118, 61, 62, 63, 64, and 65 are selected so that each possible combination of switch closures gives rise to a unique voltage drop.

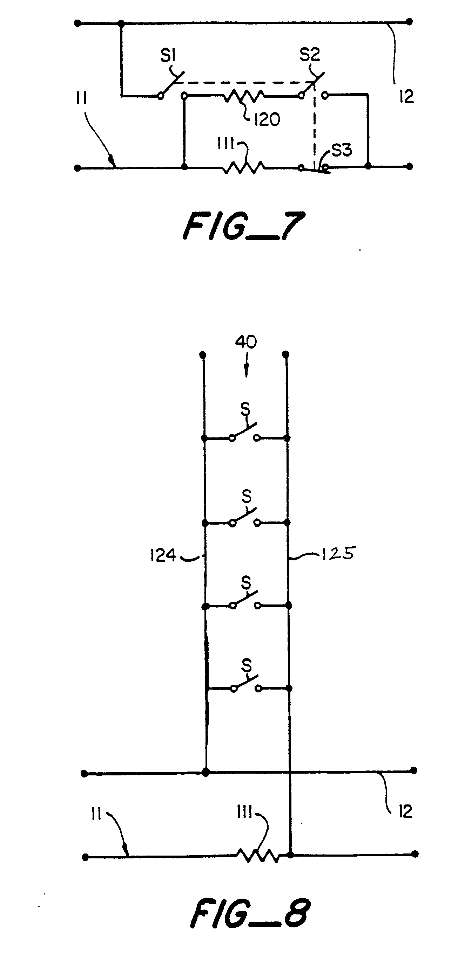

Figures 5, 6 and 7 are circuit diagrams of modules which are especially useful for systems of the general kind shown in Figure 4. By making use of a plurality of gauged switches, $S_1$, $S_2$ and $S_3$, which are operated together by the occurrence of an event at the module,

(1) in Figure 5, an additional resistor 119 is introduced into the locating member.

(2) in Figure 6, resistor 111 is removed from the locating member and resistor 61 is introduced into the connection; and

(3) in Figure 7, resistor 111 is removed from the locating member and resistor 120 is introduced into the locating member.

Modules of this kind can be used to increase the number of possible combinations of events which can give rise to unique voltage drops.

Referring now to Figure 8, this shows a module suitable for use when setting up a system which includes a number of branch lines, along each of which an event can take place, and in which system it is adequate to know, when an event has taken place on one of the branch lines, which of the branch lines is involved. Thus in Figure 8, the module provides a branch line 40 which comprises a first elongate conductor 124 for connection into the source member 12 of a system as shown in Figure 1, a second elongate conductor 125 and resistor 111 for connection into the locating member 11 of a system as shown in Figure 1, and a plurality of event-sensitive modules S which will connect the conductors 125 and 124 if an event takes place. Alternatively conductors 125 and 124 could be bare wires, or wires covered by conductive polymer, which would become connected if electrolyte was present in sufficient quantity at any point along the branch line.

**Claims**

1. A method for monitoring for the occurrence of an event, and for detecting and obtaining information about the event upon its occurrence, which method comprises providing a system in which, upon occurrence of the event,

(1) electrical connection is made between an electrically conductive locating member (11) and an electrically conductive second member (12);

the locating member comprising

(a) a plurality of spaced-apart, discrete impedant components (111, 114, 115 ...), each of which has substantial impedance, and

(b) a plurality of elongate intermediate components (112), each of which physically separates and electrically connects a pair of impedant components;

the connection to the locating member being made at at least one of a plurality of available connection points which lie between the impedant components, and at which the locating member and/or the second member comprises an event-sensitive connection means (S) that comprises a metal core and a jacket (i) which electrically surrounds the core, (ii) which is composed of a conductive polymer and (iii) through which the connection is made and the connection being effective at a first point whose location is defined by at least one characteristic of the event; the making of the connection enabling the formation of a test circuit which comprises that part of the locating member between the first point and a second point on the locating member having a known location, and in which an electrical current of known size is transmitted between the first and second points on the locating member; and the current and the locating member being such that, by measuring the voltage drop between the first and second points, the spatial relationship between the first and second points can be determined;

(2) the voltage drop between the first and second points is measured; and

(3) information concerning the event is obtained from the measurement made in step (2).

2. A method according to claim 1 wherein there is a single available connection point between each pair of impedant components and each of the impedant components is substantially identical.

3. A method according to claim 1 or 2 wherein the impedant and intermediate components have resistance but no reactance, and each of the impedant components has a resistance of at least 0.1 ohm, preferably 1 to 1000 ohms.

4. A method according to claims 1, 2 or 3 wherein the ratio of the impedance of each of the impedant components to the total impedance of all of the intermediate components is at least 100, preferably at least 1000.

5. A method according to any one of the preceding claims wherein at least one of the available connection points has associated with it an additional impedant component so that, when, but only when, connection is made between the locating and second members at that available connection point, an additional known impedance is introduced into the test circuit, and said impedant components and additional impedant components are selected so that each possible combination of connections gives rise to a unique voltage drop between the first and second points.

6. A method according to any one of the preceding claims wherein the system comprises a plurality of event-sensitive modules, each of which comprises

(a) said discrete impedant component (111);

(b) a first conductor which has a relatively very small impedance and is connected in series with the impedant component;

(c) a second conductor which also has a relatively very small impedance and which, in the absence of an event, is electrically insulated from the first conductor and the impedant component; and

(d) a said event-sensitive connection means (S) which comprises a metal core electrically surrounded by a jacket (i) which is composed of a conductive polymer and (ii) through which, upon occurrence of an event, electrical connection is effected between the first and second conductors;

the first conductors and the impedant components forming part of the locating member and the second conductors forming part of the second member, and each of said modules being electrically connected together.

7. A method according to any one of the preceding claims wherein the event is an increase in the amount of electrolyte to a level sufficient to effect electrical connection between the locating and second members through the conductive polymer jacket.

8. A method according to any one of claims 1 to 7 wherein said test circuit which is formed by the making of the connection between the locating member and the second member comprises (a) the connection, (b) the part of the locating member which lies between the first point and the second point, and (c) a power source which causes the electrical current of known size to be transmitted between the first and second points on the locating member.

9. A method according to claim 8 wherein the size of the electrical current transmitted between the first and second points on the locating member is determined by comparing the voltage drop between the first and second points with the voltage drop over a reference resistor connected in series with the locating member.

10. A method according to any one of claims 1 to 9 wherein the system comprises a plurality of branch lines (40), each branch line providing an available connection point and each branch line forming an event-sensitive connection means and comprising a first wire (125) which is covered by conductive polymer and which forms part of the locating member (11), and a second wire (124) which is covered by conductive polymer and which forms part of the second member (12).

11. Apparatus for detecting and obtaining information about an event, by a method as claimed in any one of claims 1 to 10, which apparatus comprises

(1) an elongate electrically conductive locating member (11) which comprises

(a) a plurality of spaced-apart, discrete impedant components (111, 114 ...) each of which has substantial impedance, and

(b) a plurality of elongate intermediate members (112), each of which physically separates and electrically connects a pair of impedant components;

(2) an elongate electrically conductive second member (12);

(3) a plurality of event-sensitive connection means (S)

(a) which are placed at discrete available connection points,

(b) which lie between the impedant components,

(c) which comprise a metal core and a jacket (i) which electrically surrounds the core, and (ii) which is composed of a conductive polymer, and

(d) at one or more of which, upon occurrence of an event, electrical connection is effected between the locating member (11) and the second member (12) through the conductive polymer jacket, the connection being effective at a first point on the locating member which is defined by at least one characteristic of the event;

(4) an electrically conductive third member (16);

(5) a voltage-measuring device (14) for determining the voltage drop between the first point and a second point which is at one end of the locating member, the voltage measuring device (14) being connected to the first point or to the other end of the locating member (11) through the third member (16); and

(6) a power source (15) which is electrically connected to the second point on the locating member and, which, at least when occurrence of an event causes electrical connection to be made between the locating and second members, causes a current of known size to be transmitted between the first and second points on the locating member.

12. An event-sensitive module which is suitable for use in a method for detecting and obtaining information about an event, as claimed in claim 6 and which comprises

(1) a discrete impedant component (111) having substantial impedance;

(2) a first conductor which has a relatively very small impedance and which is connected in series with the impedant component;

(3) a second conductor which also has a relatively very small impedance and which, in the absence of an event, is electrically insulated from the first conductor and the impedant component; and

(4) an event-sensitive connection means (S) which comprises a metal core and a jacket (i) which electrically surrounds the core, (ii) which is composed of a conductive polymer and (iii) through which, upon occurrence of an event, electrical connection is effected between the first and second conductors;

the impedant component and the first conductor being connectable in series with incoming and outgoing portions of elongate intermediate components of an elongate electrically conductive locating member, and the second conductor being connectable in series with incoming and outgoing portions of elongate intermediate components of an elongate electrically conductive second member.

13. A method for monitoring for the occurrence of an event, and for detecting and obtaining information about the event upon its occurrence, which method comprises providing a system in which, upon occurrence of the event,

(1) electrical connection is made between an electrically conductive locating member (11) and an electrically conductive second member (12); the locating member comprising

(a) a plurality of spaced-apart, discrete impedant components (111, 114, 115 ...), each of which has substantial impedance, and

(b) a plurality of elongate intermediate components (112), each of which physically separates and electrically connects a pair of impedant components;

the connection to the locating member being made at at least one of a plurality of available connection points which lie between the impedant components, and the connection being effective at a first point whose location is defined by at least one characteristic of the event;

the making of the connection enabling the formation of a test circuit which comprises that part of the locating member between the first point and a second point on the locating member having a known location, and in which an electrical current of known size is transmitted between the first and second points on the locating member; and the current and the locating member being such that, by measuring the voltage drop between the first and second points, the spatial relationship between the first and second points can be determined;

(2) the voltage drop between the first and second points is measured; and

(3) information concerning the event is obtained from the measurement made in step (2);

at least one of the available connection points having associated with it an additional discrete impedant component (61, 62, 63 ...) so that, when, but only when, connection is made between the locating and second members at that available connection point, an additional known impedance is introduced into the test circuit, and said impedant components and additional impedant components are selected so that each possible combination of connections gives rise to a unique voltage drop between the first and second points.

**Patentansprüche**

1. Verfahren zur Überwachung des Auftretens eines Ereignisses und zum Erfassung und Erhalten von Informationen über das Ereignis bei seinem Auftreten, wobei das Verfahren die Schaffung eines Systems umfaßt, bei dem beim Auftreten des Ereignisses folgendes geschieht:

(1) es erfolgt eine elektrische Verbindung zwischen einem elektrisch leitfähigen Ortungselement (11) und einem elektrisch leitfähigen zweiten Element (12); wobei das Ortungselement folgendes umfaßt:

(a) eine Vielzahl von beabstandeten, diskreten Impedanzkomponenten (111, 114, 115, ...), von denen jede eine wesentliche Impedanz hat, und

(b) eine Vielzahl von länglichen, dazwischenliegenden Komponenten (112), von denen jede ein Paar von Impedanzkomponenten körperlich trennt und elektrisch verbindet;

wobei die Verbindung zum Ortungselement an mindestens einem von einer Vielzahl von verfügbaren Verbindungspunkten erfolgt, die zwischen den Impedanzkomponenten liegen, und bei dem das Ortungselement und/oder das zweite Element eine ereignisempfindliche Verbindungseinrichtung (S) aufweisen, die einen Metallkern und einen Mantel umfaßt, der (i) den Kern elektrisch umgibt, der (ii) aus einem leitfähigen Polymer besteht, und durch den (iii) die Verbindung hergestellt wird und die Verbindung an einem ersten Punkt wirksam ist, dessen Ort durch mindestens eine Charakteristik des Ereignisses bestimmt ist; wobei das Herstellen der Verbindung die Bildung einer Testschaltung ermöglicht, welche den Teil des Ortungselementes zwischen dem ersten Punkt und einem zweiten Punkt auf dem Ortungselement mit einem bekannten Ort umfaßt, und bei der ein elektrischer Strom bekannter Größe zwischen den ersten und zweiten Punkten in dem Ortungselement übertragen wird; und wobei der Strom und das Ortungselement so ausgebildet sind, daß durch die Messung des Spannungsabfalls zwischen den ersten und zweiten Punkten die räumliche Relation zwischen den ersten und zweiten Punkten bestimmt werden kann;

(2) der Spannungsabfall zwischen den ersten und zweiten Punkten wird gemessen; und

(3) die Informationen bezüglich des Ereignisses werden aus der Messung erhalten, die beim Schritt (2) erfolgt.

2. Verfahren nach Anspruch 1, wobei ein einziger verfügbarer Verbindungspunkt zwischen jedem Paar von Impedanzkomponenten vorhanden ist und jede der Impedanzkomponenten im wesentlichen identisch ist.

3. Verfahren nach Anspruch 1 oder 2, wobei die Impedanzkomponenten und dazwischenliegenden Komponenten einen Widerstandswert, aber keine Reaktanz haben, und wobei jede der Impedanzkomponenten einen Widerstand von mindestens 0,1 Ohm, vorzugsweise von 1 bis 1000 Ohm hat.

4. Verfahren nach Anspruch 1, 2 oder 3, wobei das Verhältnis der Impedanz von jeder der Impedanzkomponenten zur Gesamtimpedanz von sämtlichen dazwischenliegenden Komponenten mindestens 100, vorzugsweise mindestens 1000 beträgt.

5. Verfahren nach einem der vorherigen Ansprüche, wobei mindestens einer der verfügbaren Verbindungspunkte eine ihm zugeordnete zusätzliche Impedanzkomponente hat, so daß dann, aber nur dann, wenn eine Verbindung zwischen dem Ortungselement und dem zweiten Element an diesem verfügbaren Verbindungspunkt hergestellt wird, eine zusätzliche bekannte Impedanz in die Testschaltung eingeführt wird, und wobei die Impedanzkomponenten und die zusätzlichen Impedanzkomponenten so gewählt sind, daß jede mögliche Kombination von Verbindungen einen eindeutigen Spannungsabfall zwischen den ersten und zweiten Punkten verursacht.

6. Verfahren nach einem der vorherigen Ansprüche, wobei das System eine Vielzahl von ereignisempfindlichen Modulen aufweist, von denen jeder folgendes umfaßt:

(a) die erwähnte diskrete Impedanzkomponente (111);

(b) einen ersten Leiter, der eine relativ sehr kleine Impedanz hat und mit der Impedanzkomponente in Reihe geschaltet ist;

(c) einen zweiten Leiter, der ebenfalls eine relativ sehr kleine Impedanz hat und der, in Abwesenheit eines Ereignisses, von dem ersten Leiter und der Impedanzkomponente elektrisch isoliert ist; und

(d) die erwähnte ereignisempfindliche Verbindungseinrichtung (S), die einen Metallkern aufweist, der von einem Mantel elektrisch umgeben ist, der (i) aus einem leitfähigen Polymer besteht und durch den (ii), beim Auftreten eines Ereignisses, eine elektrische Verbindung zwischen den ersten und zweiten Leitern vorgenommen wird;

wobei die ersten Leiter und die Impedanzkomponenten einen Teil des Ortungselementes bilden und die zweiten Leiter einen Teil des zweiten Elementes bilden, und wobei sämtliche Module elektrisch miteinander verbunden sind.

7. Verfahren nach einem der vorherigen Ansprüche, wobei das Ereignis eine Zunahme der Menge eines Elektrolyten auf einen Wert ist, der ausreichend ist, um eine elektrische Verbindung zwischen dem Ortungselement und dem zweiten Element durch den leitfähigen Polymermantel zu bewirken.

8. Verfahren nach einem der Ansprüche 1 bis 7, wobei die Testschaltung, welche durch das Herstellen der Verbindung zwischen dem Ortungselement und dem zweiten Element hergestellt wird, folgendes aufweist: (a) die Verbindung, (b) den Teil des Ortungselementes, der zwischen dem ersten Punkt und dem zweiten Punkt liegt, und (c) eine Stromquelle, die bewirkt, daß der elektrische Strom bekannter Größe zwischen den ersten und zweiten Punkten in dem Ortungselement übertragen wird.

9. Verfahren nach Anspruch 8, wobei die Größe bzw. Stromstärke des elektrischen Stromes, der zwischen den ersten und zweiten Punkten in dem Ortungselement übertragen wird, bestimmt wird durch Vergleichen des Spannungsabfalls zwischen den ersten und zweiten Punkten mit dem Spannungsabfall über einem Referenzwiderstand, der mit dem Ortungselement in Reihe geschaltet ist.

10. Verfahren nach einem der Ansprüche 1 bis 9, wobei das System eine Vielzahl von Zweigleitungen (40) aufweist, wobei jede Zweigleitung einen verfügbaren Verbindungspunkt liefert und jede Zweigleitung eine ereignisempfindliche Verbindungseinrichtung bildet und einen ersten Draht (125), der mit dem leitfähigen Polymer überzogen ist und der einen Teil des Ortungselementes (11) bildet, sowie einen zweiten Draht (124) aufweist, der mit dem leitfähigen Polymer überzogen ist und einen Teil des zweiten Elementes (12) bildet.

11. Vorrichtung zum Erfassen und Erhalten von Informationen über ein Ereignis, mit einem Verfahren nach einem der Ansprüche 1 bis 10, wobei die Vorrichtung folgendes aufweist:

(1) ein längliches, elektrisch leitfähiges Ortungselement (11), welches folgendes umfaßt:

(a) eine Vielzahl von beabstandeten, diskreten Impedanzkomponenten (111, 114, ...), von denen jede eine wesentliche Impedanz hat, und

(b) eine Vielzahl von länglichen, dazwischenliegenden Elementen (112), von denen jedes ein Paar von Impedanzkomponenten körperlich trennt und elektrisch verbindet;

(2) ein längliches, elektrisch leitfähiges zweites Element (12);

(3) eine Vielzahl von ereignisempfindlichen Verbindungseinrichtungen (S),

(a) die an diskreten verfügbaren Verbindungspunkten angeordnet sind,

(b) die zwischen den Impedanzkomponenten liegen,

(c) die einen Metallkern und einen Mantel aufweisen, der (i) den Kern elektrisch umgibt und der (ii) aus einem leitfähigen Polymer besteht, und

(d) bei denen an einer oder mehreren von ihnen, beim Auftreten eines Ereignisses, eine elektrische Verbindung gebildet wird zwischen dem Ortungselement (11) und dem zweiten Element (12) durch den leitfähigen Polymermantel, wobei die Verbindung wirksam ist an einem ersten Punkt in dem Ortungselement, der bestimmt ist durch mindestens eine Charakteristik des Ereignisses;

(4) ein elektrisch leitfähiges drittes Element (16);

(5) eine Spannungsmeßeinrichtung (14) zur Bestimmung des Spannungsabfalls zwischen dem ersten Punkt und einem zweiten Punkt, der an einem Ende des Ortungselementes liegt, wobei die Spannungsmeßeinrichtung (14) an den ersten Punkt oder das andere Ende des Ortungselementes (11) durch das dritte Element (16) angeschlossen ist; und

(6) eine Stromquelle (15), die elektrisch an den zweiten Punkt an dem Ortungselement angeschlossen ist und die, zumindest dann, wenn das Auftreten eines Ereignisses das Herstellen einer elektrischen Verbindung zwischen dem Ortungselement und dem zweiten Element hervorruft, bewirkt, daß ein Strom bekannter Größe zwischen den ersten und zweiten Punkten an dem Ortungselement übertragen wird.

12. Ereignisempfindlicher Modul, der zur Verwendung in einem Verfahren zum Erfassen und Erhalten von Informationen über ein Ereignis geeignet ist, nach Anspruch 6, der folgendes aufweist:

(1) eine diskrete Impedanzkomponente (111) mit einer wesentlichen Impedanz;

(2) einen ersten Leiter, der eine relativ sehr kleine Impedanz hat und der mit der Impedanzkomponente in Reihe geschaltet ist;

(3) einen zweiten Leiter, der ebenfalls eine relativ sehr kleine Impedanz hat und der, in Abwesenheit eines Ereignisses, von dem ersten Leiter und der Impedanzkomponente elektrisch isoliert ist; und

(4) eine ereignisempfindliche Verbindungseinrichtung (S), die einen Metallkern und einen Mantel aufweist, der (i) den Kern elektrisch umgibt, der (ii) aus einem leitfähigen Polymer besteht, und durch den (iii), beim Auftreten eines Ereignisses, eine elektrische Verbindung zwischen den ersten und zweiten Leitern hergestellt wird;

wobei die Impedanzkomponente und der erste Leiter in Reihe mit hineinführenden und hinausführenden Teilen der länglichen, dazwischenliegenden Komponenten eines länglichen, elektrisch leitfähigen Ortungselementes schaltbar sind, und wobei der zweite Leiter in Reihe mit hineinführenden und hinausführenden Teilen der länglichen, dazwischenliegenden Komponenten eines länglichen, elektrisch leitfähigen zweiten Elementes schaltbar ist.

13. Verfahren zur Überwachung des Auftretens eines Ereignisses und zum Erfassen und Erhalten von Informationen über das Ereignis bei seinem Auftreten, wobei das Verfahren die Schaffung eines Systems umfaßt, bei dem beim Auftreten des Ereignisses folgendes geschieht:

(1) es erfolgt eine elektrische Verbindung zwischen einem elektrisch leitfähigen Ortungselement (11) und einem elektrisch leitfähigen zweiten Element (12); wobei das Ortungselement folgendes aufweist:

(a) eine Vielzahl von beabstandeten, diskreten Impedanzkomponenten (111, 114, 115, ...), von denen jede eine wesentliche Impedanz hat, und

(b) eine Vielzahl von länglichen, dazwischenliegenden Komponenten (112), von denen jede ein Paar von Impedanzkomponenten körperlich trennt und elektrisch verbindet;

wobei die Verbindung mit dem Ortungselement an mindestens einem von einer Vielzahl von verfügbaren Verbindungspunkten erfolgt, die zwischen den Impedanzkomponenten liegen, und wobei die Verbindung an einem ersten Punkt wirksam ist, dessen Ort durch mindestens eine Charakteristik des Ereignisses definiert ist;

wobei das Herstellen der Verbindung die Bildung einer Testschaltung ermöglicht, die den Teil des Ortungselementes umfaßt, der zwischen dem ersten Punkt und einem zweiten Punkt an dem Ortungselement mit einem bekannten Ort liegt, und bei der ein elektrischer Strom bekannter Größe zwischen den ersten und zweiten Punkten an dem Ortungselement übertragen wird; und wobei der Strom und das Ortungselement so sind, daß durch die Messung des Spannungsabfalls zwischen den ersten und zweiten Punkten die räumliche Relation zwischen den ersten und zweiten Punkten bestimmt werden kann;

(2) der Spannungsabfall zwischen den ersten und zweiten Punkten wird gemessen; und

(3) die Informationen bezüglich des Ereignisses werden aus der beim Schritt (2) erfolgten Messung erhalten;

wobei zumindest einem der verfügbaren Verbindungspunkte eine zusätzliche diskrete Impedanzkomponente (61, 62, 63, ...) zugeordnet ist, so daß dann, aber nur dann, wenn die Verbindung zwischen dem Ortungselement und dem zweiten Element an diesem verfügbaren Verbindungspunkt hergestellt wird, eine zusätzliche bekannte Impedanz in die Testschaltung eingeführt wird, und wobei die Impedanzkomponenten und die zusätzlichen Impedanzkomponenten so gewählt sind, daß jede mögliche Kombination von Verbindungen einen eindeutigen Spannungsabfall zwischen den ersten und zweiten Punkten verursacht.

**Revendications**

1. Procédé de contrôle pour déceler l'apparition d'un événement, et pour détecter et obtenir une information concernant l'événement à la suite de son apparition, lequel procédé consiste à utiliser un système dans lequel, à la suite de l'apparition de l'événement,

(1) une connexion électrique est établie entre un élément électriquement conducteur (11) de localisation et un second élément électriquement conducteur (12);

l'élément de localisation comprenant

(a) un groupe de composants espacés (111, 114, 115 ...) à impédances discrètes ayant chacun une impédance importante; et

(b) un groupe de composants intermédiaires allongés (112) qui, chacun, séparent physiquement et connectent électriquement deux composants à impédance;

la connexion sur l'élément de localisation étant effectuée en au moins l'un de plusieurs points de connexion disponibles qui s'étendent entre les composants à impédances, et auquel l'élément de localisation et/ou le second élément comprennent un moyen (S) de connexion sensible à un événement qui comporte une âme métallique et une gaine (i) qui entoure électriquement l'âme, (ii) qui est composée d'un polymère conducteur et (iii) par l'intermédiaire de laquelle la connexion est réalisée, et la connexion étant effective en un premier point dont l'emplacement est défini par au moins une caractéristique de l'événement;

l'établissement de la connexion permettant la formation d'un circuit d'essai qui comprend la partie de l'élément de localisation située entre le premier point et un second point sur l'élément de localisation ayant un emplacement connu, et dans lequel un courant électrique de valeur connue est transmis entre les premier et second points sur l'élément de localisation; et le courant et l'élément de localisation étant tels que, en mesurant la chute de tension entre les premier et second points, on peut déterminer la relation spatiale entre les premier et second points;

(2) la chute de tension entre les premier et second points est mesurée; et (3) une information concernant l'événement est obtenue d'après la mesure réalisée à l'étape (2).

2. Procédé selon la revendication 1, dans lequel il y a un seul point de connexion disponible entre chaque paire de composants à impédances et tous les composants à impédances sont sensiblement identiques.

3. Procédé selon la revendication 1 ou 2, dans lequel les composants à impédances et intermédiaires ont une résistance, mais aucune réactance, et chacun des composants à impédances possède une résistance d'au moins 0,1 ohm, avantageusement de 1 à 1000 ohms.

4. Procédé selon les revendications 1, 2 ou 3, dans lequel le rapport de l'impédance de chacun des composants à impédances à l'impédance totale de tous les composants intermédiaires est d'au moins 100, de préférence d'au moins 1000.

5. Procédé selon l'une quelconque des revendications précédentes, dans lequel au moins un composant à impédance supplémentaire est associé à au moins l'un des points de connexion disponibles de manière que, quand, mais seulement quand, une connexion est établie entre l'élément de localisation et le second élément en ce point de connexion disponible, une impédance connue supplémentaire soit introduite dans le circuit d'essai, et lesdits composants à impédances et les composants à impédances supplémentaires sont choisis de manière que chaque combinaison possible de connexions donne naissance à une chute de tension unique entre les premier et second points.

6. Procédé selon l'une quelconque des revendications précédentes, dans lequel le système comprend plusieurs modules sensibles à un événement, comprenant chacun

(a) l'un desdits composants à impédances discrètes (111);

(b) un premier conducteur qui possède une impédance relativement très faible et qui est connecté en série avec le composant à impédance;

(c) un second conducteur qui possède aussi une impédance relativement très faible et qui, en l'absence d'un événement, est isolé électriquement du premier conducteur et du composant à impédance; et

(d) l'un desdits moyens (S) de connexion sensibles à un événement qui comprend une âme métallique entourée électriquement d'une gaine (i) qui est composée d'un polymère conducteur et (ii) par l'intermédiaire de laquelle, à la suite de l'apparition d'un événement, une connexion électrique est effectuée entre les premier et second conducteurs;

les premiers conducteurs et les composants à impédances faisant partie de l'élément de localisation et les seconds conducteurs faisant partie du second élément, l'élément de localisation comprenant ledit groupe de composants intermédiaires allongés et le second élément comprenant un autre groupe de composants intermédiaires qui connectent électriquement ensemble les modules sensibles à un événement.

7. Procédé selon l'une quelconque des revendications précédentes, dans lequel l'événement est une augmentation de la quantité d'électrolyte à un niveau suffisant pour établir une connexion électrique entre l'élément de localisation et le second élément par l'intermédiaire de la gaine en polymère conducteur.

8. Procédé selon l'une quelconque des revendications 1 à 7, dans lequel ledit circuit d'essai qui est formé par l'établissement de la connexion entre l'élément de localisation et le second élément comprend (a) la connexion, (b) la partie de l'élément de localisation qui s'étend entre le premier point et le second point, et (c) une source d'énergie qui provoque la transmission du courant électrique de valeur connue entre les premier et second points sur l'élément de localisation.

9. Procédé selon la revendication 8, dans lequel la valeur du courant électrique transmis entre les premier et second points sur l'élément de localisation est déterminée par une comparaison de la chute de tension entre les premier et second points avec la chute de tension sur une résistance de référence connectée en série avec l'élément de localisation.

10. Procédé selon l'une quelconque des revendications 1 à 9, dans lequel le système comprend plusieurs conduites de branchement (40), chaque conduite de branchement réalisant un point de connexion disponible et chaque conduite de branchement formant un moyen de connexion sensible à un événement et comprenant un premier fil (125) qui est recouvert de polymère conducteur et qui fait partie de l'élément (11) de localisation, et un second fil (124) qui est recouvert d'un polymère conducteur et qui fait partie du second élément (12).

11. Appareil pour détecter et obtenir une information concernant un événement, par un procédé selon l'une quelconque des revendications 1 à 10, lequel appareil comprend

1) un élément allongé (11) de localisation, électriquement conducteur, qui comprend

(a) un groupe de composants espacés (111, 114 ..) à impédances discrètes, ayant chacun une impédance importante, et

(b) un groupe d'éléments intermédiaires allongés (112) qui, chacun, séparent physiquement et connectent électriquement deux composants à impédances;

(2) un second élément allongé et électriquement conducteur (12);

(3) un groupe de moyens (S) de connexion sensibles à un événement;

(a) qui sont placés en des points de connexion disponibles discrets,

(b) qui s'étendent entre les composants à impédances,

(c) qui comprennent une âme métallique et une gaine (i) qui entoure électriquement l'âme et (ii) qui est composée d'un polymère conducteur, et

(d) en un ou plusieurs desquels, à la suite de l'apparition d'un événement, une connexion électrique est établie entre l'élément (11) de localisation et le second élément (12) par l'intermédiaire de la gaine en polymère conducteur, la connexion étant effective en un premier point sur l'élément de localisation qui est défini par au moins une caractéristique de l'événement;

(4) un troisième élément électriquement conducteur (16);

(5) un dispositif (14) de mesure de tension destiné à déterminer la chute de tension entre le premier point et un second point qui est à une extrémité de l'élément de localisation, le dispositif (14) de mesure de tension étant connecté au premier point ou à l'autre extrémité de l'élément (11) de localisation par l'intermédiaire du troisième élément (16); et

(6) une source d'énergie (15) qui est connectée électriquement au second point sur l'élément de localisation et qui, au moins lorsque l'apparition d'un événement provoque l'établissement d'une connexion électrique entre l'élément de localisation et le second élément, provoque la transmission d'un courant de valeur connue entre les premier et second points sur l'élément de localisation.

12. Module sensible à un événement, qui convient à une utilisation dans un procédé pour détecter et obtenir une information concernant un événement, selon la revendication 6, et qui comprend

(1) un composant à impédance discrète (111) ayant une impédance importante;

(2) un premier conducteur qui possède une impédance relativement très faible et qui est connecté en série avec le composant à impédance;

(3) un second conducteur qui possède aussi une impédance relativement très faible et qui, en l'absence d'un événement, est isolé électriquement du premier conducteur et du composant à impédance; et

(4) un moyen (S) de connexion sensible à un événement, qui comprend une âme métallique et une gaine (i) qui entoure électriquement l'âme, (ii) qui est composée d'un polymère conducteur et (iii) par l'intermédiaire de laquelle, à la suite de l'apparition d'un événement, une connexion électrique est effectuée entre les premier et second conducteurs;

le composant à impédance et le premier conducteur pouvant être connectés en série avec les parties entrante et sortante de composants intermédiaires allongés d'un élément de localisation allongé et électriquement conducteur, et le second conducteur pouvant être connecté en série avec des parties entrante et sortante de composants intermédiaires allongés d'un second élément allongé et électriquement conducteur.

13. Procédé de contrôle pour déceler l'apparition d'un événement, et pour détecter et obtenir une information concernant l'événement à la suite de son apparition, lequel procédé consiste à utiliser un système dans lequel, à la suite de l'apparition de l'événement,

(1) une connexion électrique est établie entre un élément électriquement conducteur (11) de localisation et un second élément électriquement conducteur (12);

l'élément de localisation comprenant

(a) un groupe de composants espacés (111, 114, 115 ...) à impédances discrètes, ayant chacun une impédance importante, et

(b) un groupe de composants intermédiaires allongés (112) qui, chacun, séparent physiquement et connectent électriquement deux composants à impédances;

la connexion sur l'élément de localisation étant effectuée en au moins l'un d'un groupe de points de connexion disponibles qui s'étendent entre les composants à impédances, et la connexion étant effective en un premier point dont l'emplacement est défini par au moins une caractéristique de l'événement;

l'établissement de la connexion permettant la formation d'un circuit d'essai qui comprend la partie de l'élément de localisation située entre le premier point et un second point sur l'élément de localisation ayant un emplacement connu, et dans lequel un courant électrique de valeur connue est transmis entre les premier et second points sur l'élément de localisation; et le courant et l'élément de localisation étant tels qu'en mesurant la chute de tension entre les premier et second points, on peut déterminer la relation spatiale entre les premier et second points;

(2) la chute de tension entre les premier et second points est mesurée; et

(3) une information concernant l'événement est obtenue d'après la mesure effectuée à l'étape (2);

un composant à impédance discrète supplémentaire (61, 62, 63 ...) étant associé à au moins l'un des points de connexion disponibles de manière que, quand, mais seulement quand, une connexion est établie entre l'élément de localisation et le second élément en ce point de connexion disponible, une impédance supplémentaire connue soit introduite dans le circuit d'essai, et lesdits composants à impédances et composants à impédances supplémentaires sont choisis de manière que chaque combinaison possible de connexions donne naissance à une chute de tension unique entre les premier et second points.

FIG_1

FIG_2

FIG_3

EP 0 164 838 B1

*FIG_4*

*FIG_5*

*FIG_6*

2

FIG_7

FIG_8